# EUROPEAN PATENT SPECIFICATION

(11) **EP 0 469 605 B1**
(45) Date of publication and mention of the grant of the patent: **12.06.1996**
(21) Application number: 91112951.8
(22) Date of filing: 01.08.1991
(51) Int. Cl.: H01S 3/025, H01L 33/00

(54) **Process for reducing characteristics degradation of a semiconductor laser**
Verfahren um die Verschlechterung der Eigenschaften eines Halbleiterlasers zu verringern
Procédé pour réduire la dégradation des caractéristiques d'un laser à semi-conducteur

(30) Priority: 01.08.1990 JP 204527/90
(43) Date of publication of application: 05.02.1992
(73) Proprietor: SUMITOMO ELECTRIC INDUSTRIES, LIMITED, Osaka 541 (JP)
(72) Inventor: Shikata, Shinichi, c/o Yokohama Works of Sumitomo, Yokohama-shi, Kanagawa (JP)
(74) Representative: Kahler, Kurt, Dipl.-Ing.

(56) References cited:
- JAPANESE JOURNAL OF APPLIED PHYSICS, SUPPLEMENTS. EXTENDED ABSTRACTS 21TH CONFERENCE ON SOLID STATE DEVICES AND MATERIALS (1989) 28 August 1989, TOKYO JA,pages 337 - 340; H. KAWANISHI ET AL: 'Effects of (NH4)2S treatments on the characteristics of AlGaAs laser diodes'
- JAPANESE JOURNAL OF APPLIED PHYSICS. vol. 23, no. 8, August 1984, TOKYO JP; K. WAKITA ET AL.: 'Small surface damage facet coating on InGaAsP/InP laser by ECR plasma deposition'
- JOURNAL OF APPLIED PHYSICS. vol. 67, no. 1, 1 January 1990, NEW YORK US pages 586 - 588; C.J SANDROFF ET AL: 'Enhanced electronic properties of GaAs surfaces chemically passivated by Selenium reactions'
- JOURNAL OF APPLIED PHYSICS. vol. 67, no. 4, 15 February 1990, NEW YORK US pages 2162 - 2165; K.C WANG ET AL: 'A study of new surface passivation using P2S5/ (NH4)2S on GaAs schottky barrier diodes'
- JOURNAL OF VACUUM SCIENCE AND TECHNOLOGY: PART B. vol. 6, no. 4, July 1988, NEW YORK US pages 1174 - 1179; R. IYER ET AL: 'The effect of phosphorous and sulfur treatment on the surface properties of InP'
- PROC. OF THE 17TH INT. SYMPOSIUM ON GALLIUM ARSENIDE AND RELATED COMPOUNDS 24 September 1990, JERSEY, CHANNEL ISLANDS UK pages 251 - 256; S. SHIKATA ET AL: 'Suppression of the emitter size effect on the current gain of AlGaAs/GaAs HBT by utilizing (NH4)2Sx treatment'

## Description

### Background of the Invention

This invention relates to a process for reducing characteristics degradation of a semiconductor laser and comprises the protection of the side surfaces of the resonator thereof.

### (Related Background Art)

A known major factor for the degradation of the characteristics of a semiconductor laser is degradation of the side surfaces of the resonator. Prior art for the prevention of such degradation are described, e.g., in Japanese Patent Publication Nos. 37828/1987, 34835/1985 and 43910/1988. On the other hand, "Effects of (NH₄)₂S Treatments on the Characteristics of AlGaAs Laser Diodes" (Extended Abstract of the 21st Conference on Solids Devices and Materials, Tokyo, 1989, pp. 337-340) describes the art for preventing the degradation of the side surfaces of the resonator of a semiconductor laser by reducing the interface states by sulfur passivation.

But the effect of the sulfur passivation is not sufficient to appreciate the prevention of the degradation of the side surfaces of the resonator. In view of the problem of the above-described prior art, the inventors made various studies and found a process for forming a protection film for a semiconductor laser, which can effectively prevent the degradation of the side surfaces of the resonator.

### Summary of the Invention

In comparing the protection films formed by various processes, the inventors found the fact that the sulfur passivated side surfaces of a resonator are very sensitive to the following protection film forming process, and ECR-CVD can suppress the degradation of the effect of the sulfur-passivation.

That is, the process for forming a protection film for a semiconductor laser this invention relates to is characterized in that the side surfaces of the semiconductor laser are sulfur-passivated, and subsequently a protection film is formed by ECR-CVD. In ECR-CVD, the reaction chamber is divided in a plasma generating chamber and a film forming chamber, and the plasma does not damage the side surfaces of a resonator. Resultantly the effect of the sulfur passivation is not degraded. Prior to the sulfur-passivation, the side surfaces of a resonator may be treated with a phosphoric acid-based etchant, whereby the protection effect of the side surfaces of the resonator can be more improved.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art form this detailed description.

### Brief Description of the Drawings

FIG. 1 is a perspective view of a semiconductor laser fabricated substrate an embodiment of this invention is applied to;
FIG. 2 is a graph comparing the protection effect of a side surface of a resonator among different kinds of passivated protection films; and
FIG. 3 is a graph of the effect of phosphoric acid-based etchants.

### Description of the Preferred Embodiment

Embodiments of this invention will be explained below with reference to the drawings attached hereto.

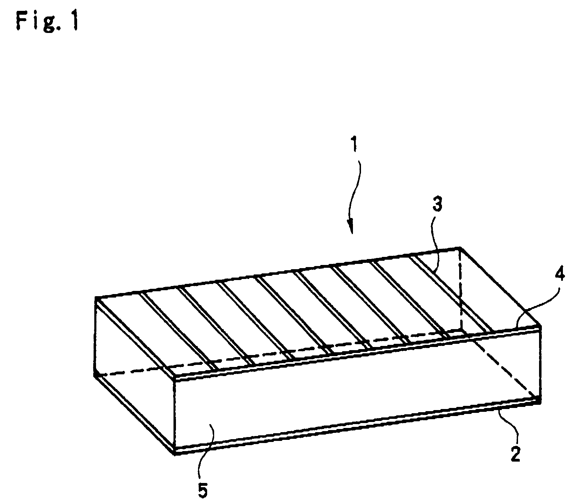

FIG. 1 is a perspective view of a semiconductor laser the process according to this invention is applicable to. As shown in FIG. 1, a rod-shaped laser crystal 1 is cloven to form the side surfaces of a resonator. An n-electrode 2 is formed on the bottom surface, and stripe regions 3 and p-electrodes 4 are alternately formed on the top surface. The laser crystal 1 has AlGaAs double hetero-structure but may have AlInGaP/GaAs structure, InGaAsP/InP structure or others.

Firstly a cleavage plane 5 (a side surface of a resonator) of the laser crystal 1 is sulfur-passivated by sulfur reaction. The cleavage plane 5 is immersed in a solution of (NH₄)₂S or (NH₄)₂S_{X} (1≤x≤3) to terminate dangling bonds in the cleavage plane 5. The cleavage plane 5 may be treated with a phosphoric acid-based etchant prior to the sulfur passivation. The latter treatment prevents the natural formation of an oxide film, and is suitable for the case that a protection film is not immediately formed on the cleavage plane 5. Subsequently a protection film is formed by ECR-CVD. As materials of this protection film, SiNx, SiO₂, SiON, etc. can be used. When the above-described treatment is completed, the laser crystal 1 of FIG. 1 is cloven in the longitudinal direction of the stripe regions 3. Thus, a desired semiconductor laser device is fabricated.

Next, embodiments of the process according to this invention will be explained below.

Samples were prepared as follows. First a laser crystal of AlGaAs double hetero junction-structure was prepared. A Ti/Pt/Au p type-electrode was formed on the surface on the side of the p type-semiconductor crystal, and an AuGe/Ni/Au n type-electrode was formed on the surface on the side of the n-semiconductor. This rod-shaped crystal was cloven on both sides to form side surfaces of a resonator. The thus-prepared samples were subjected to the treatments of Example 1, and Comparisons 1 and 2 which will be described below.

### Example 1

Immediately after the cleavage, a sample was immersed in a solution of (NH₄)₂S_{X} for 10 minutes and then water-cleaned. Then the sample held by a jig was placed in the film forming chamber of an ECR-CVD apparatus so that a film is formed on the cleavage plane, and a SiN film was formed using SiH₄ and N₂ gases. At this time, the p type- and n type-electrode forming portions were covered with metal films attached to jigs so that the SiN film is not formed on the p type-electrode and the n type-electrode. But it is not especially necessary to cover the electrode forming portions, because the radical ion shower from the plasma generating chamber to the film forming chamber has such a high directivity that few ions turn in. Consequently the resultant semiconductor laser has few recombinations on the side surfaces of the resonator and little natural oxide film.

### Comparison 1

The cleavage plane of a sample was sulfur-passivated by the same process as in Example 1. Then the sample was set in a sputtering apparatus, and a SiO₂ film was formed on the cleave plane.

### Comparison 2

Immediately after the cleavage, without the sulfur passivation, a sample was set in a sputtering apparatus, and a SiO₂ film was formed on the cleavage plane.

Laser diodes using the thus-treated samples were compared first in laser beam output. The laser diode of Example 1 exhibited an output 1.5 times that of Comparison 1, and 3 times that of Comparison 2. Next in current supply degradation characteristic, the laser diodes were compared. At 60 C°, the laser diode of Example 1 exhibited a lifetime 4 times that of Comparison 1 and 20 time that of Comparison 2.

Next, various film forming processes were compared in PL (photoluminescence) intensity.

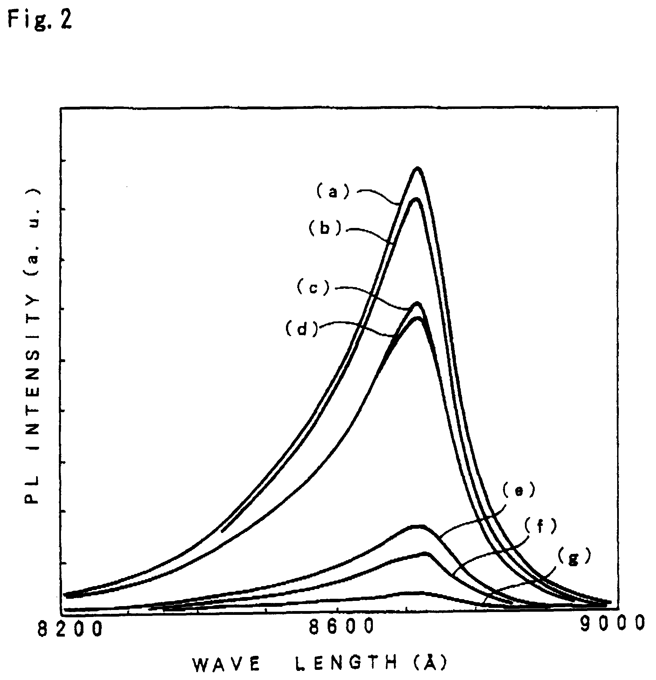

The result of this comparison is shown in FIG. 2. Curve (a) in FIG. 2 shows the photoluminescence of the case in which the sulfur passivation was followed by the formation of a silicon oxide protection film. A high photoluminescence intensity was obtained at the band edge. Curve (b) shows the photoluminescence intensity of the case where the sulfur-passivation was performed, but no protection film was formed. These curves show that the effect of the sulfur passivation is not degraded at all by using ECR-CVD. This will be the reason why the plasma generating chamber and the film forming chamber are separated in ECR-CVD apparatus, and the plasma shower does not damage the side surfaces of a resonator.

Curve (c) shows the photoluminescence intensity of the case where the film was formed by sputtering, and Curve (d) shows that of the case where the film was formed by pyrolytic CVD. It is found that the effect of the sulfur passivation in these cases is degraded in comparison with that of ECR-CVD. Curve (e) shows the photoluminescence intensity of the film formed by the plasma CVD at RF of 13.56 MHz. Curve (g) shows the photoluminescence of the film formed by the plasma CVD at RF of 50 KHz. It is seen that the effect of the sulfur passivation is much reduced. Curve (d) shows the photoluminescence of the case where none of the treatments were made.

Next, the effect of the treatment with a phosphoric acid-based etchant followed by the sulfur passivation was compared in terms of photoluminescence intensity.

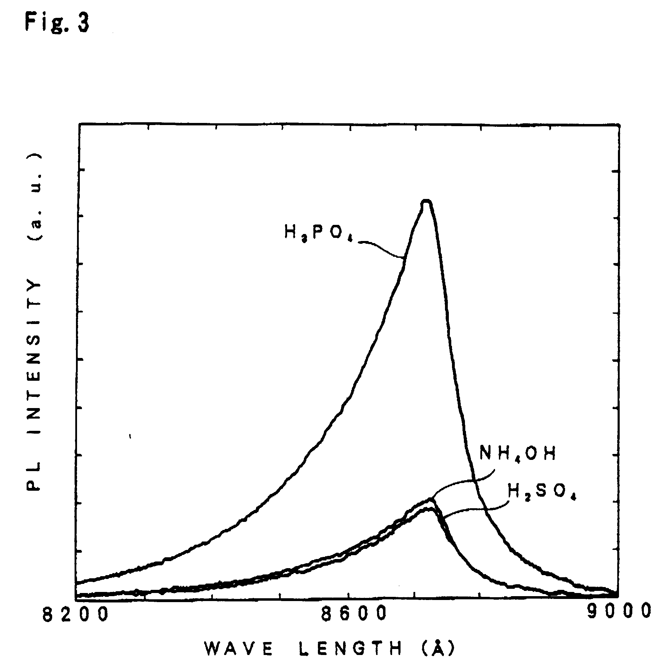

The result of this comparison is shown in FIG. 3. As shown in FIG. 3, when a sample is lightly etched with an isotropic etchant containing H₃PO₄, photoluminescence intensity is higher at the wavelength corresponding to the band edge. In contrast to this, it is found that when a sample is etched with the anisotropic etchant, such as ammonia- or sulfuric acid-based etchants, no great improvement is made. Here the isotropic etchant means etchants which form etched surfaces in inversed and normal mesas, and phosphoric acid-based etchants form etched surfaces in generally normal mesas and are called here isotropic etchants.

In the above embodiment, sulfur passivation treatment is applied to a surface of the semiconductor substrate after etching with a phosphoric acid-based etchant. While, selenium is one element in VI group in which sulfur is included and has chemical properties similar to that of sulfur. Further, atomic radius of selenium is nearer to those of Ga and As than that of sulfur and therefore it is possible that the selenium surface layer has lower energy level than that of sulfur surface layer and as the result is more stable than that of sulfur. See Journal of Applied Physics Vol. 67 No. 1, 1 January 1990, pages 586 to 588, "Enhanced electronic properties of GaAs surface chemically passivated by selenium reactions".

In view of the above, the passivation treatment using selenium can be applied to the surface of the semiconductor substrate instead of the sulfur passivation treatment of the above embodiment and the advantageous effect in the surface states density which is obtained by the sulfur passivation may be also obtained by the selenium passivation.

As described above, in this invention, for the formation of a protection for semiconductor lasers, ECR-CVD is used to form a passivated protection film. Consequently side surfaces of the resonators which are little degraded and have good reflection characteristics can be realized. Furthermore, the effects can be further improved by the treatment with isotropic etchants, such as phosphoric acid-based etchants.

From the invention thus described, it will be obvious that the invention may be varied in many ways. Such variations are not to be regarded as a departure from the scope of the invention, and all such modifications as would be obvious to one skilled in the art are intended to be included within the scope of the following claims.

## Claims

1. A process for forming a protection film on a semiconductor laser containing Ga and As, comprising the steps of:
etching side surfaces of a resonator of said semiconductor laser with a phosphoric acid-based etchant; sulfur-passivating the etched side surfaces after the etching step; and
forming a protection film on the sulfur-passivated side surfaces by Electron Cyclotron resonance-CVD after the sulfur-passivating step.

2. A process of claim 1,
wherein the sulfur passivation is performed by immersing the resonator side surfaces in an ammonium sulfide excessively containing sulfur.

3. A process of any preceding claim,
wherein the protection film is made of silicon oxide, silicon nitride or silicon nitrogen oxide.

4. A process of any preceding claim,
comprising the step of selenium-passivating the side surfaces instead of sulfur-passivating thereof.

## Patentansprüche

1. Ein Verfahren zum Ausbilden einer Schutzschicht auf einem Ga und As enthaltenden Halbleiterlaser, das die Schritte aufweist:
Ätzen von Seitenflächen eines Resonators des Halbleiterlasers mit einem auf Phosphorsäure basierenden Ätzmittel; Schwefel-Passivierung der geätzten Seitenflächen nach dem Ätzschritt; und
Ausbilden einer Schutzschicht auf den Schwefelpassivierten Seitenflächen mittels Elektronen-Zyklotron-Resonanz-CVD nach dem Schwefel-Passivierungsschritt.

2. Ein Verfahren nach Anspruch 1,
wobei die Schwefel-Passivierung durch Eintauchen der Resonatorseitenflächen in ein Ammoniumsulfit durchgeführt wird, das übermäßig Schwefel enthält.

3. Ein Verfahren nach einem vorhergehenden Anspruch,
wobei die Schutzschicht aus Siliciumoxid, Siliciumnitrid oder Silicium-Stickstoff-Oxid hergestellt wird.

4. Ein Verfahren nach einem vorhergehenden Anspruch, das den Schritt der Selen-Passivierung der Seitenflächen anstelle von deren Schwefel-Passivierung aufweist.

## Revendications

1. Procédé de formation d'un film protecteur sur un émetteur laser à semi-conducteur contenant Ga et As, comprenant les étapes :
de décapage des surfaces latérales d'un résonateur dudit émetteur laser à semi-conducteur avec un agent décapant à base d'acide phosphorique; de passivation au soufre des surfaces latérales décapées suite à l'étape de décapage; et
de formation d'un film de protection sur les surfaces latérales passivées au soufre par résonance électronique du cyclotron-CVD suite à l'étape de passivation au soufre.

2. Procédé selon l'une quelconque des revendications précédentes, dans lequel la passivation au soufre se fait par immersion des surfaces latérales du résonateur dans du sulfure d'ammonium contenant un excès de soufre.

3. Procédé selon l'une quelconque des revendications précédentes, dans lequel le film protecteur est fabriqué en oxyde de silicium, en nitrure de silicium ou en oxyde d'azote de silicium.

4. Procédé selon l'une quelconque des revendications précédentes, comprenant l'étape de passivation des surfaces latérales au sélénium au lieu d'une passivation des surfaces au soufre.
